(19) **Europäisches Patentamt / European Patent Office / Office européen des brevets**

(11) **EP 2 158 620 B1**

(12) **EUROPEAN PATENT SPECIFICATION**

(45) Date of publication and mention of the grant of the patent:
**12.10.2011 Bulletin 2011/41**

(21) Application number: **08753966.4**

(22) Date of filing: **23.05.2008**

(51) Int Cl.:
**C09K 9/00** (2006.01)

(86) International application number:
**PCT/SE2008/000349**

(87) International publication number:
**WO 2008/147282 (04.12.2008 Gazette 2008/49)**

(54) **PIEZOCHROME COMPOSITE**

PIEZOCHROME ZUSAMMENSETZUNG

COMPOSITE DE PIÉZOCHROME

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **25.05.2007 SE 0701261**

(43) Date of publication of application:
**03.03.2010 Bulletin 2010/09**

(73) Proprietor: **Totalförsvarets Forskningsinstitut
164 90 Stockholm (SE)**

(72) Inventors:
• **FAGERSTRÖM, Jan**
  **S-590 74 Ljungsbro (SE)**
• **LOPES, Cesar**
  **S-582 16 Linköping (SE)**
• **SVENSSON, Sören**
  **S-583 31 Linköping (SE)**
• **PAROLA, Stéphane**
  **F-69330 Jonage (FR)**

(74) Representative: **Hedefält, Dag
Försvarets Materielverk
Patentenheten
S-115 88 Stockholm (SE)**

(56) References cited:
**WO-A1-00/21905      WO-A2-02/087858
US-A- 2 420 864**

• **DATABASE WPI Week 197809 Thomson Scientific, London, GB; AN 1978-16560A XP002591763 & JP 53 004897 A (MATSUSHITA ELEC IND CO LTD) 17 January 1978 (1978-01-17) & JP 53 004897 A (MATSUSHITA ELEC IND CO LTD) 17 January 1978 (1978-01-17)**
• **JELENA JEFTIC ET AL: "A helium-gas-pressure apparatus with optical-reflectivity detection tested with a spin-transition solid" MEASUREMENT SCIENCE AND TECHNOLOGY, IOP, BRISTOL, GB LNKD- DOI: 10.1088/0957-0233/10/11/314, vol. 10, no. 11, 1 November 1999 (1999-11-01), pages 1059-1064, XP020064854 ISSN: 0957-0233**
• **GREENBERG ET AL: "Optically switchable thin films: a review" THIN SOLID FILMS, ELSEVIER-SEQUOIA S.A. LAUSANNE, CH LNKD- DOI: 10.1016/0040-6090(94)90668-8, vol. 251, no. 2, 1 November 1994 (1994-11-01), pages 81-93, XP024577720 ISSN: 0040-6090 [retrieved on 1994-11-01]**
• **MOLNAR G ET AL: "Raman Spectroscopic Study of Pressure Effects on the Spin-Crossover Coordination Polymers (Fe(Pyrazine)[M(CN)4].2H2O (M = Ni, Pd, Pt). First Observation of a piezo-Hysteresis Loop at Room Temperature" JOURNAL OF PHYSICAL CHEMISTRY. B (ONLINE), AMERICAN CHEMICAL SOCIETY, COLUMBUS, OH, US LNKD- DOI: 10.1021/JP027550Z, vol. 107, 1 January 2003 (2003-01-01), pages 3149-3155, XP003023533 ISSN: 1520-5207 [retrieved on 2003-03-14]**
• **JEFTIC J. ET AL.: 'A helium-gas-pressure apparatus with optical-reflectivity detection based with a spin-transition solid' MEAS. SCI. TECHNOL. vol. 10, 1999, pages 1059 - 1064, XP020064854**

**(Cont. next page)**

- MOLNAR G. ET AL.: 'Raman Spectroscopic Study of Pressure Effects on the Spin-Crossover Coordination Polymers (Fe(Pyrazine)[M(CN)4]. 2H2O (M = Ni, Pd, Pt). First Observation of a piezo-Hysteresis Loop at Room Temperature' J. PHYS. CHEM. B vol. 107, 2003, pages 3149 - 3155, XP003023533

**Description**

**Summary of the invention**

The following invention relates to a piezochrome composite and a device comprising such a piezochrome composite. More specifically it relates to a composite with particles embedded into a matrix of an optically transparent, or partly transparent, piezoelectric material. These particles consist of particles of a spin-transition compound that displays spectrally different optical characteristics in their different spin states. As a consequence of the latter fact the composite has been termed piezochrome composite. The piezoelectric matrix, in which the particles of the spin-transition compound are embedded, is also provided with electrodes which could be connected to an external voltage supply through electric wires. When a voltage is supplied over the piezoelectric material the material will respond by creating mechanical strain or contraction in the matrix and a mechanical stress in the particles. This supplied electric voltage will increase the pressure over the particles in the composite and this will lead to a shift in their spin state. How this happens physically will be described in what follows. The shift in the spin state induced by the change of pressure will lead to changed optical spectral characteristics for the spin transition particles in the composite. This will find use as a part of an optical filter, both a transmission and reflection filter, but the device can also be used as a type of temperature sensor. Beside these it is also possible to find an application where a device according to the invention is part of an optical display.

**Background to the invention**

Spin transition compounds or spin transition materials (alternatively "spin cross-over material" or even "spin equilibrium material") are materials that can be manipulated so as to change their spin state from a high spin state to a low spin state. The present invention makes use of the fact that certain spin transition compounds displays different optical characteristics depending on the spin state of the compound. There has been written a lot of articles and books (see, for example, "Spin transitions in metal compounds I", published by Springer, first edition (June 24 2004)) about this phenomenon and a lot of the background to this specific part of the invention can be found in these articles and books. Further background art can be found in the following documents.

DATABASE WPI week 197809, Thomson Scientific, AN 1978-16560A XP002591763, where it is disclosed a material consisting of an organic piezochromic compound dispersed in a piezoelectric compound. The organic compound is o-oxybenzylidene-p-toluidinedianthrone or hexaphenyl-biimidazolyl, and the piezoelectric high polymer is polyimide, polyvinylidine fluoride or polyvinyl fluoride. The composite material is formed into a thin film which is electrically polarized.

"A helium-gas-pressure apparatus with optical reflectivity detection tested with a spin-transition solid", Jelena Jeftic, et al, MEASUREMENT SCIENCE AND TECHNOLOGY. IOP BRISTOL, GB, vol 10, no 11 1 November 1999, pages 1059-1064, describes an apparatus which can be used to measure the optical reflectivity of a substance at a well-controlled pressure and temperature. The function of the apparatus is verified using the spin-transition substance (Fe(btr)2(NCS)2)H2O. This document does not disclose the spin transition substance as a component of a piezochromic composite.

"Optically switchable thin films: a review", Greenberg et al, in THIN SOLID FILMS, ELSEVIER-SEQUIOA, vol 251 no 2, 1 November 1994, pages 81-93, is a review of optically switchable thin film. It includes materials with electrochromic, thermochromic, piezochromic or photochromic properties. The document does not disclose spin transition materials as part of a composite.

Molnar, G et al analyzes the spin transition coordination polymers (Fe(Pyrazine)(M(CN)4).2H2O (M=Ni, Pd, Pt) using Raman spectroscopy in the article "Raman spectroscopic study of pressure effects on the Spin-crossover coordination polymers (Fe(Pyrazine)(M(CN)4).2H2O (M=Ni, Pd, Pt). First observation of a piezo-hystereses loop at room temperature", published in Journal of Physical Chemistry vol 107, 1 January 2003, pages 3149 - 3155. A high pressure cell is used. No composites including spin transition materials are disclosed in the document.

In what follows it suffices, unless stated otherwise, to notice that the invention makes use of the fact that the spin transition compounds displays different optical characteristics depending on the dominating spin state in the compound. As for the piezoelectric materials are these materials that can be manipulated mechanically by means of applying an electric voltage, i.e. an electric voltage applied over the material will alter the crystal structure of the material and give a contraction or expansion. The purpose of the present invention is to provide a composite containing a matrix of an optical transparent piezoelectric material which contains particles of a spin transition compound that displays different optical characteristics depending on their spin state. Furthermore the present invention provides a device containing this composite and that also provides a mechanism that makes it possible to control the spin transitions in the material. Generally the spin transitions occur as a result of temperature changes for spin transition compounds. The notation $T_{1/2\downarrow\uparrow}$ will be used do denote the critical temperature. The notation is meant to show that there exist two different critical temperatures for a spin transition. An arrow pointing upwards denotes transitions to the high spin state while an arrow pointing downwards denotes transitions to the low spin state. Spin transition can also occur as the result of pressure changes over the material, that the material is irradiated or as a consequence of an applied magnetic field. The device according to claims 4 or 5 of the present invention makes use of the fact that the spin transition temperature can be shifted by means of a pressure change and the device can therefore be used to control the spin transitions in the material by controlling this temperature shift. This shift of the critical temperature makes it possible to view the critical temperature as a sort of parameter that depends on the pressure state of the material.

How the spin transitions are controlled can briefly be described by the following steps (it is assumed in the following process that there is a locally constant temperature, that this temperature is higher than the initial critical temperature or, as an alternative, that the device is provided with a temperature stabilizer that keeps the composite at a constant temperature higher than the initial critical temperature for the spin transition compound):

i) Particles of the spin transition compound is embedded into a matrix of a optically transparent piezoelectric material;
ii) The matrix of the piezoelectric material is provided with electrodes that are connected to an external voltage supply through electrical wires;
iii) When the voltage generated in the external voltage supply is applied to the electrodes in the matrix the piezoelectric material is contracted and as a consequence the spin transition particles is exposed to a pressure change (an increase in pressure), this pressure change makes the critical temperature for the material to be shifted upwards;

$$T_{1/2\downarrow\uparrow} \Rightarrow T'_{1/2\downarrow\uparrow} > T_{1/2\downarrow\uparrow}$$

iv) When the critical temperature, which is now shifted upwards due to the applied pressure, crosses the surrounding temperature $T_f$, which is initially higher then the critical temperature this will lead to a shifted spin state for the spin transition compound.

The controlling of the spin state transition is now obtained by controlling the applied voltage so as to obtain a shift of the critical temperature through a pressure change. More about this can be found in the part about preferred embodiments.

**Drawings**

In the drawings:

Fig.1. discloses a diagram that displays applied electric voltage per meter piezochrome composite relative the mechanical stresses on a particle of a spin transition compound embedded in a piezoelectric material.

Fig.2. discloses a possible embodiment of the piezochrome device according to the present invention.

Fig.3. discloses another possible embodiment of the device according to the present invention wherein the device also contains a temperature stabilizing casing given the reference numeral 6.

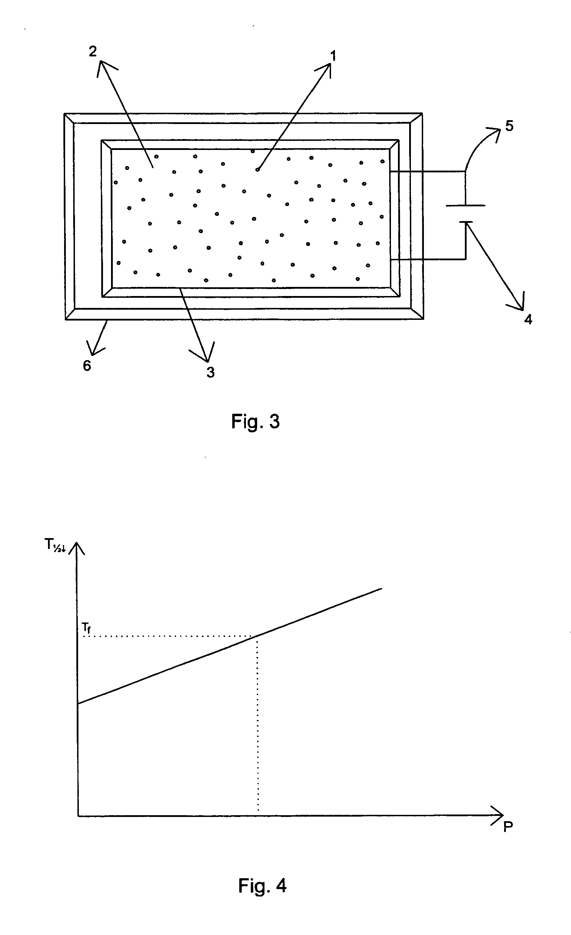

Fig.4. discloses a curve that schematically (and linearly) shows how the critical temperature is shifted upwards and crosses the temperature of the local surrounding. The spin transition occurs when $T_{1/2\downarrow}$ crosses $T_f$. The curve $T_{1/2\downarrow}$ as a function of P is here given as a linear curve. It is possible that the pressure dependence for certain materials is of a non-linear nature and it might be necessary to perform measurements to obtain the exact relation. It can be foreseen that non-linear relations could be preferred for certain application as in this case a smaller pressure change would make the critical temperature increase faster than in the case of a linear relation. This could be an advantage if one wants to avoid applying to high a voltages over the composite.

Fig. 5. discloses how a device according to a specific embodiment of the present invention is used as a part of an optical filter.

Fig.6. discloses an alternative variant of the device in figure 5.

**Preferred embodiments**

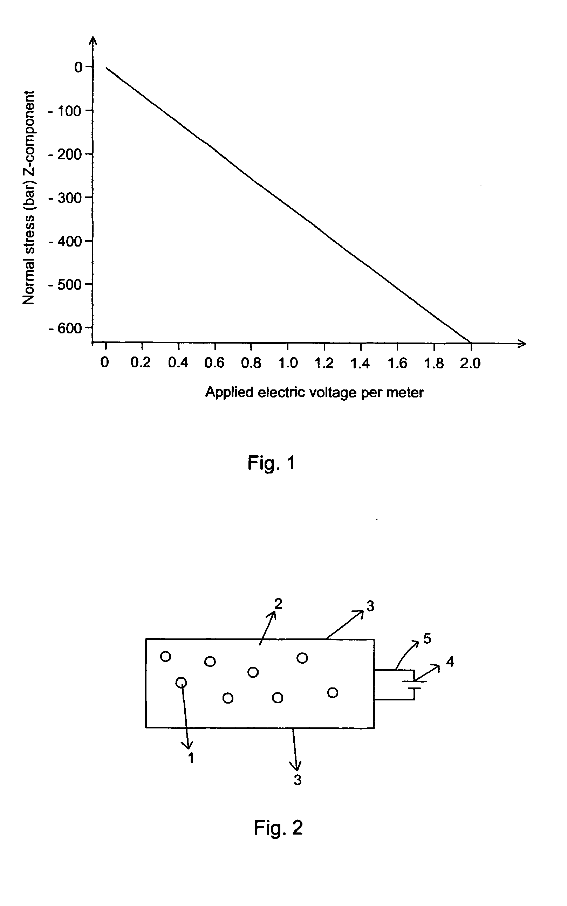

With reference to the drawings a number of preferred embodiments of the device according to the device will be presented. With reference to figure 2, which discloses a schematic sketch of the piezochrome device according to claim 4, reference numeral 1 represents a particle of a spin transition compound, reference numeral 2 represents a matrix of a optically transparent piezoelectric material, reference numeral 3 represents electrodes provided on the boundary of the matrix, reference numeral 4 represents the external voltage supply and reference numeral 5 represents electrical wires extending between the voltage supply and the electrodes in the matrix. This type of device does not provide for a controllable influence on the spin transitions. The reason behind this is that the temperature induced spin transitions occurs at the spin transition temperatures (such a temperature exists, as already been mentioned, for the transitions to the low spin state as well as for the high spin state, wherein the latter temperature is higher) and hence the spin transitions will only occur at these specific temperatures. Below there is given a table that gives certain examples of spin transition compounds that displays different optical characteristics in their different spin states and, in certain cases, their relating spin transition temperatures. The temperatures are given to give a rough guide to what temperatures it concerns. It is easy though to determine the critical temperature for a given spin transition compound. One could, for example, use an oil bath and vary the temperature and observe when a change in the spectral optical characteristics occurs.

| Spin transition compounds | $T_c$, $T_{1/2}\uparrow$, $T_{1/2}\downarrow$ (at 1 atm) Kelvin |
|---|---|
| $Fe(phen)_2(NCS)_2$ | $T_c \approx 176$ K |
| $[Fe(btr)_2(NCS)_2]\cdot H_2O$ | $T_{1/2}\uparrow = 144$ K, $T_{1/2}\downarrow = 121$ K |
| $Fe\text{-}(4\text{-}Amino\text{-}1,2,4\text{-}triazol)_3(BF_4)_2$ | $T_{1/2}\uparrow = 322$ K, $T_{1/2}\downarrow = 308$ K |
| $Fe(hyptrz)_3(4chlorobenzenesulfonate)_2\cdot H_2O$, where hyptrz = 4-(3'-hydroxpropyl)-1,2,4-triazole | App. 180 K |
| $Fe(PM\text{-}Bia)_2(NCS)_2$, where PM-Bia = N-(2'-pyridyl-methylene)-4-amino-bi-phenyl | App. 170 K |
| $Fe(PM\text{-}Aza)_2(NCS)_2$, where PM-Aza = N-(2'-pyridyl-methylene)-4-(azophenyl) aniline | App. 200 K |

**Table 1.**

Beside the above given compounds there is a number of different and well-known spin transition compounds that displays the desired characteristics for the present invention, for example:

Fe $(ptz)_6(BF_4)_2$;
$[Fe(Atrz)_3](NO_3)_2\cdot nH_2O$, where Atrz = 4-amino-1,2,4-triazole;
Fe $(phy)_2(BF_4)_2$, where phy = 1,10-phenanthroline-2-carbaldehydephenylhydrazone)
$Fe(pyrazine)[M(CN)_4]\cdot 2H_2O$, where M = Ni, Pd;
$(Fe_xNi_{1-x}(btr)_2(NCS)_2]\cdot H_2O$;
$[CrI_2(depe)_2]$, where depe = 1,2-bis(diethylphosphino)ethane;
$[Fe(mtz)_6](BF_4)_2$, where mtz = 1-methyl-tetrazole;
$Fe(abpt)_2(NCS)_2$, where abpt = 4-amino-3,5-bis(pyridin-2-yl)-1,2,4-triazole;
$[Fe(bpb)_2(NCS)_2]\cdot 0.5meOH$, where bpb = 1,4-bis(4-pyridyl)butadiyne;
$Fe(pz)_2[M(CN)_4]\cdot 2H_2O$, where pz = pyrazine, M = Ni, Pd, Pt;
$Fe(4,4'\text{-}bipy)_2[Ag(CN)_2]_2$, where bipy = bipyridine;
$Fe(bpe)_2[Ag(CN)_2]_2$, where bpe = *trans*-1,2-Bis(4-pyridyl)ethylene

The above given table and the subsequent exemplified spin transition compounds is not an exhaustive list of possible spin transition compounds that displays the desired characteristics, instead it only gives a subgroup of these. It is construed that all possible spin transition compounds that displays characteristics necessary for the present invention, that is have different spectrally optical characteristics in their different spin states, is covered by the term spin transition compound in the appended claims.

Also the piezoelectric material shall display certain characteristics to make the present invention possible. Mainly the piezoelectric material should be optically transparent or at least partly optically transparent. The last case could be preferable if the composite or the device according to the invention should be used as part of an optic display. Below there is given certain examples of such optically transparent piezoelectric materials. The list is not exhaustive instead it only gives a few examples. Any piezoelectric material that is optically transparent or partly optically transparent is assumed to fall within the scope of the appended claims.

Possible piezoelectric materials that can be used as part of the composite:

$BaTiO_3$, $Pb(Zr_xTi_{1-x})O_3$(PZT- 5H, PZT- 5A), $(CH_2CF_2)_n$ (poly vinylidin difluoride, PVDF).

It is possible to use a device according to claim 4 as part of a temperature sensor that reacts at a certain threshold value. This threshold value will correspond to the critical temperature of the spin transition compound. When using a device according to figure 2 as part of a temperature sensor a well gauged voltage will be applied over the composite of the piezoelectric material and the spin transition particles. The particles will initially be in a specific spin state with the optical characteristics that correspond to the compound in this state. When the temperature is getting closer and crosses the critical temperature of the compound a spin transition will occur in the compound which alters the optical characteristics. This change could be detected with suitable means and a signal could be generated as a consequence. This signal could be modulated and processed in different ways and then sent to alert the user that the threshold value has been reached / surpassed.

To overcome the problem of obtaining controllable spin transitions without spontaneous temperature induced spin transitions an alternative embodiment of the present invention could be used. For this embodiment reference is made to figure 3 where said figure discloses a piezochrome device according to claim 5. This device is, beside the parts described with reference to figure 1, also provided with a temperature stabilizing casing 6 that encases the piezochrome composite and the electrodes provided thereon. Preferably the external voltage supply is also external to the temperature stabilizing device. By use of such a temperature stabilizing device it is possible to influence the spin states in the piezochrome composite regardless of the temperature outside the device. The fundamental idea is that the composite shall experience an actual temperature $T_f$ that is slightly above the critical temperature. Thereby an increased pressure will give as a result that the critical temperature gets shifted upwards and that the actual temperature gets crossed and, as a consequence thereof that the spin transition compound shifts spin states. Temperature stabilising devices as used in this embodiment are well-known and commercially available and will therefore not be described in any detail here.

Due to the use of a temperature stabilising device it is now possible to influence the optical characteristics of the spin transition compounds by means of applying a voltage over the electrodes in the matrix. A few applications for a device according to claim 5 will be described in the coming section. The voltage that is needed to change the spin state of a material is dependent on the specific material and need to be measured if it is not given in a handbook. As an example of the voltage magnitude reference is made to figure 1, in this figure the mechanical stress in a piezoelectric material is plotted against the applied electric voltage. In this curve one particle is simulated and one can see that the demand on the voltage is linear with regard to the mechanical stress. Hence one must apply a large electrical voltage over the matrix to get a large contraction in the composite or, equivalently, a large pressure to shift the spin states of the spin transition particles.

**Applications**

In what follows a number of different applications of the device according to the present invention will be described. Even if the applications that are described are relatively few it can be foreseen that it is possible for a skilled artisan to find further applications where the explicit characteristics of the present invention is wanted. Such applications where the explicit characteristics of the present invention are used are considered to fall within the scope of the invention as defined in claim 1.

As the first application of the invention the use of the device as part of a temperature sensor will be described in greater detail. A conventional temperature sensor is generally referred to as an element that registers the temperatures in the surroundings, often by making use of the fact that the conductivity of a material is temperature dependent, and then generates some sort of signal that informs the user about the temperature. There is a whole range of possibilities to design such a sensor and many of these possibilities are functioning continuously over a rather wide temperature interval. When it comes to the present invention one can foresee two different ways to use the device as part of a temperature sensor. In both of these applications a piezochrome device according to claim 4 is intended. Firstly the device can, as have already been mentioned, be used as a sort of threshold temperature sensor where the critical temperature for the spin transition compound is registered by noticing that the compounds optical characteristics changes when the critical temperature is reached and crossed. This can be reached from an initial temperature that is below or above the critical temperature. When this critical temperature is crossed it is possible to register the altered characteristics of the spin transition compounds and then send some sort of signal to inform that the temperature has been reached. Secondly a piezochrome composite according to claim 1 can be used as a part in a more active temperature sensor if one adds electrodes to the composite and connect these electrodes to a voltage supply. In this case it is possible to search actively after a temperature by performing small changes of the voltage that is supplied to the electrodes in the composite. As in the earlier case use is made of the fact that the optical characteristics of the material are changed as a consequence of the spin transition. For example, given that the temperature of the surrounding is above the critical temperature of the spin transition compound, a small variation of the voltage at this constant surrounding temperature would lead to a spin transition for the spin transition compound at a specific applied voltage. In this case the actual and the sought for temperature of the surrounding corresponds to the shift of the critical temperature that the applied voltage brought about.

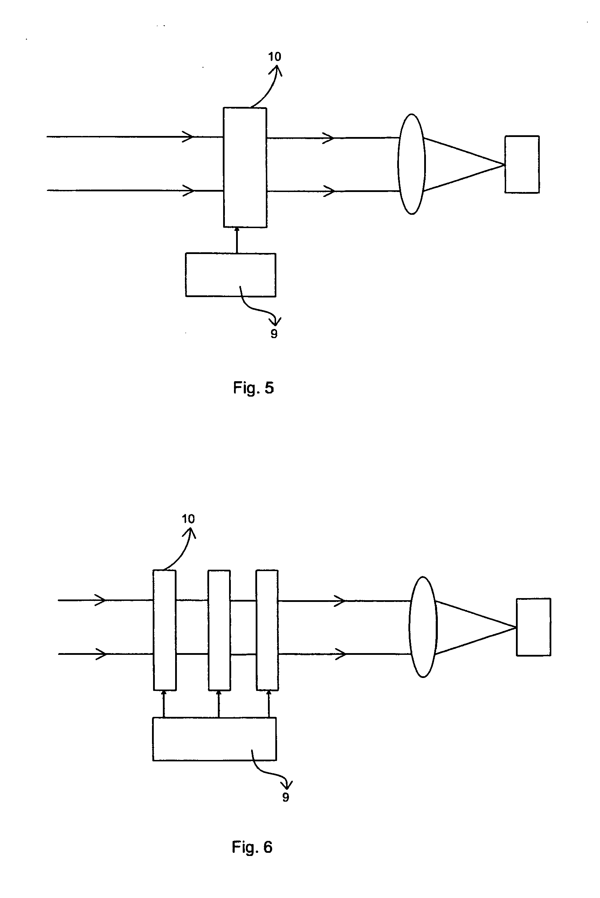

As a second application of the piezochrome device according to the present invention reference is made to figure 5, said figure discloses the use of a device according to claim 5. This application relates to the use of the invention as part of a controllable and wave-length selective optical filter. The application is illustrated in figure 5 and 6. The component that needs to be added to the device according to claim 4 to obtain the simplest version of a system for a controllable filter is control electronics 9 which are connected to the filter 10 that is designated to filter the pulses.

The control electronics 9 is designed to change the voltage over a filter component that includes the piezochrome composite according to claim 1. During use the filter 10 will change its optical state, as a result of the spin transition in the composite, from a transmitting to an absorbing state. One has thereby obtained a controllable optical filter. Needless to say the used spin transition compound has to be selected in such a way that it can absorb the desired wavelength. To overcome this limitation it is possible to foresee another application wherein a number of different piezochrome composites are used. For this specific application reference is made to figure 6, this figure gives the filter system according to figure 5 but the single filter 10 in the last application is now replaced with three different filters where each of these exhibits different optical characteristics. The different optical characteristics can be obtained by using spin transition compounds that are absorbing in different wavelength intervals. The functionality in this application is obtained in the same manner as in the previously described application with the difference that the control electronics only activates the filter component that filters the desired wavelength. Generally an application like this could use a very large number of filters where each of these filters consists of piezochrome composites that absorb light in different wavelength intervals.

Finally it is possible to foresee the use of a piezochrome device according to claim 5 as a part in an optical display.

## Claims

1. Piezochrome composite **characterised in that** it comprises a number of particles of a spin transition compound embedded in a matrix of an at least partially optically transparent piezoelectric material, said spin transition compound exhibits different optical characteristics in its different spin states.

2. Piezochrome composite according to claim 1 **characterised in that** the piezoelectric material is chosen from the group containing: $BaTiO_3$, $Pb(Zr_xTi_{1-x})O_3$ (PZT - 5H, PZT - 5A), $(CH_2CF_2)_n$ (poly vinylidin difluoride, PVDF).

3. Piezochrome composite according to claim 1-2 **characterised in that** the particles of a spin transition compound is chosen from the group containing:

   $Fe(ptZ)_6(BF_4)_2$;
   $[Fe(Atrz)_3](NQ_3)_2 \cdot nH_2O$, where Atrz = 4-amino-1,2,4-triazole;
   $Fe(phy)_2(BF_4)_2$, where phy = 1,10-phenanthroline-2-carbaldehydephenylhydrazone);
   $Fe(pyrazine)[M(CN)_4] \cdot 2H_2O$, where M = Ni, Pd;
   $[Fe_xNi_{1-x}(btr)_2(NCS)_2] \cdot H_2O$; $[Crl_2(depe)_2]$, where depe = 1,2-bis(diethylphosphino)ethane;
   $[Fe(mtz)_6](BF_4)_2$, where mtz = 1-methyl-tetrazole;
   $Fe(abpt)_2(NCS)_2$, where abpt = 4-amino-3,5-bis(pyridin-2-yl)-1,2,4-triazole;
   $(Fe(bpb)2(NCS)2] \cdot 0.5MeOH$, where bpb = 1,4-bis(4-pyridyl)butadiyne;
   $Fe(pz)_2[M(CN)_4] \cdot 2H_2O$, where pz = pyrazine, M = Ni, Pd, Pt; $Fe(4,4'-bipy)_2[Ag(CN)_2]_2$, where bipy = bipyridine;
   $Fe(bpe)_2[Ag(CN)_2]_2$, where bpe = trans-1,2-Bis(4-pyridyl)ethylene;
   $Fe(phen)_2(NCS)_2$
   $[Fe(btr)_2(NCS)_2] \cdot H_2O$;
   $Fe-(4-Amino-1,2,4-triazol)_3(BF_4)_2$;
   $Fe(hyptrz)_3(4-chlorobenzenesulfonate)_2 \cdot H_2O$, where hyptrz = 4-(3'-hydroxpropyl)-1,2,4-triazole;
   $Fe(PM-Bia)_2(NCS)_2$, where PM-Bia = N-(2'-pyridyl-methylene)-4-amino-biphenyl;
   $Fe(PM-Aza)_2(NCS)_2$, where PM-Aza = N-(2'-pyridyl-methylene)-4-(azophenyl)aniline.

4. Piezochrome device **characterised in that** said device comprises a piezochrome composite according to claims 1 -3 and electrodes provided on said piezoelectric matrix, wherein said electrodes can be connected to a, from the matrix, externally provided voltage supply through electric wires.

5. Piezochrome device according to claim 4 **characterised in that** it further comprises a temperature stabilising device, said temperature stabilising device is provided relative the matrix in such a way that the, from the matrix external, voltage supply also is external relatively the temperature stabilising device.

6. Use of a piezochrome device according to claim 5 as part of a controllable optical filter.

7. Use of a piezochrome device according to claim 4 as part of a temperature sensor for detecting a temperature threshold value.

8. Use of a piezochrome device according to claim 5 as part of an optical display.

**Patentansprüche**

1. Piezochromer Verbundwerkstoff, **dadurch gekennzeichnet, dass** der piezochrome Verbundwerkstoff eine Anzahl von Partikeln einer in eine Matrix aus mindestens teilweise optisch transparentem piezoelektrischem Material eingebetteten Spinübergang-Verbindung aufweist, welche Spinübergang-Verbindung in ihren verschiedenen Spin-Zuständen verschiedene optische Eigenschaften aufweist.

2. Piezochrome Verbundwerkstoff nach Anspruch 1, **dadurch gekennzeichnet, dass** das piezoelektrische Material aus der Gruppe ausgewählt wird, die beinhaltet: *BaTiO$_3$, Pb(Zr$_x$Ti$_{1-x}$)O$_3$(PZT - 5H,PZT - 5A), (CH$_2$CF$_2$)$_n$* (Polyvinylidendifluorid, PVDF).

3. Piezochromer Verbundwerkstoff nach Anspruch 1 bis 2, **dadurch gekennzeichnet, dass** die Partikel einer Spinübergang-Verbindung aus der Gruppe ausgewählt werden, die beinhaltet:

   Fe(ptz)$_6$(BF$_4$)2;
   [Fe(Atrz)$_3$](NO$_3$)$_2$.$n$H2O, wobei Atrz = 4-Amino-1,2,4-Triazol;
   Fe(phy)$_2$(BF$_4$)$_2$, wobei phy = 1,10-Phenanthrolin-2-Carbaldehydphenylhydrazon);
   Fe(Pyrazin)[M(CN)$_4$]·2H$_2$O, wobei M = Ni, Pd;
   [FexNi$_{1-x}$(btr)$_2$(NCS)$_2$]·H$_2$O; [Crl$_2$(depe)$_2$], wobei depe = 1,2-bis(Diethylphosphino)ethan;
   [Fe(mtz)$_6$](BF$_4$)$_2$, wobei mtz = 1-Methyl-Tetrazol;
   Fe(abpt)$_2$(NCS)$_2$, wobei abpt = 4-Amino-3,5-bis(Pyridin-2-yl)-1,2,4-Triazol;
   [Fe(bpb)2(NCS)2]·0,5MeOH, wobei bpb = 1,4-bis(4-Pyridyl)Butadiyne;
   Fe(pz)$_2$[M(CN)$_4$]·2H$_2$0, wobei pz = Pyrazin, M = Ni; Pd, Pt; Fe(4,4'-bipy)$_2$[Ag(CN)$_2$]$_2$, wobei bipy = Bipyridin;
   Fe(bpe)$_2$[Ag(CN)$_2$]$_2$, wobei bpe = trans-1,2-Bis(4-Pyridyl)Ethylen;
   Fe(phen)$_2$(NCS)$_2$
   [Fe(btr)$_2$(NCS)$_2$]·H$_2$O
   Fe-(4-Amino-1,2,4-Triazol)$_3$(BF$_4$)$_2$;
   Fe(hyptrz)$_3$(4-Chlorbenzolsulfonat)$_2$·H$_2$O, wobei hyptrz = 4-(3'-Hydroxypropyl)-1,2,4-Triazol;
   Fe(PM-Bia)$_2$(NCS)$_2$, wobei PM-Bia = N-(2'-Pyridyl-Methylen)-4-Amino-Biphenyl;
   Fe(PM-Aza)$_2$(NCS)$_2$, wobei PM-Aza = N-(2'-Pyridyl-Methylen)-4
   (Azophenyl)Anilin.

4. Piezochrome Vorrichtung, **dadurch gekennzeichnet, dass** die Vorrichtung einen piezochromen Verbundwerkstoff gemäß den Ansprüchen 1 bis 3 sowie Elektroden auf genannter piezoelektrischer Matrix aufweist, wobei besagte Elektroden mit einer extern der Matrix zur Verfügung gestellten Spannungsversorgung durch elektrische Drähte in Verbindung stehen können.

5. Piezochrome Vorrichtung nach Anspruch 4, **dadurch gekennzeichnet, dass** die Vorrichtung zusätzlich eine Temperaturstabilisierungsvorrichtung aufweist, welche Temperaturstabilisierungsvorrichtung derart im Verhältnis zur Matrix vorgesehen ist, dass die zur Matrix externe Spannungsversorgung auch relativ zur Temperaturstabilisierungsvorrichtung extern ist.

6. Nutzung der piezochromen Vorrichtung nach Anspruch 5 als Teil eines steuerbaren optischen Filters.

7. Nutzung der piezochromen Vorrichtung nach Anspruch 4 als Teil eines Temperatürsensors zur Erfassung eines Temperaturschwellenwertes.

8. Nutzung der piezochromen Vorrichtung nach Anspruch 5 als Teil einer optischen Anzeigevorrichtung.

**Revendications**

1. Composite de piézochrome, **caractérisé en ce qu'**il renferme une série de particules d'un composé à transition de spin noyées dans une matrice d'un matériau piézo-électrique au moins partiellement optiquement transparent, ce composé à transition de spin présentant différentes caractéristiques optiques dans ses différents états de spin.

2. Composite de piézochrome conforme à la revendication 1, **caractérisé en ce que**
   le matériau piézo-électrique est choisi dans le groupe renfermant :

   $BaTiO_3$, $Pb(Zr_xTi_{1-x})O_3$(PZT-5H, PZT-5A), $(CH_2CF_2)_n$ (difluorure de poly vinylidine PVDF).

3. Composite de piézochrome conforme à la revendication 1-2, **caractérisé en ce que**
   les particules du composé de transition de spin sont choisies dans le groupe renfermant les composés suivants :

   $Fe(ptz)_6(BF_4)_2$;
   $[Fe(Atrz)_3](NO_3)_2$ $n$H$_2$O, où Atrz = 4-amino-1,2,4-triazole;
   $Fe(phy)_2(BF_4)_2$, où phy = 1,10-phénanthroloine-2-carbaldehydephenyltydrazone);
   $Fe(pyrazine)[M(CN_4]$ 2H$_2$O, où M = Ni, Pd;
   $[Fe_xNi_{1-x}(btr)_2(NCS)_2]$ H$_2$O; $[Crl_2(depe)_2]$, où depe = 1,2-bis(diéthylphosphino)éthane;
   $[Fe(mtz)_6](BF_4)_2$, où mtz = 1-méthyl-tétrazole;
   $Fe(abpt)_2(NCS)_2$, où abpt = 4-amino-3,5-bis(pyridin-2-yl)-1,2,4-triazole;
   $[Fe(bpb)2(NCS)2]$ 0,5MeOH, où bpb = 1,4-bis(4-pyridyl)butadiyne;
   $Fe(pz)_2[M(CN)_4]$ 2H$_2$O, où pz = pyrazine, M = Ni, Pd, Pt; $Fe(4,4'-bipy)_2[Ag(CN)_2]_2$, où bipy = bipyridine;
   $Fe(bpe)_2[Ag(CN)_2]_2$, où bpe = *trans*-1,2-Bis(4-pyridyl)éthylène;
   $Fe(phen)_2(NCS)_2$;
   $[Fe(btr)_2(NCS)_2]$ H$_2$O;
   $Fe-(4-Amino-1,2,4-triazol)_3(BF4)_2$;
   $Fe(hyptrz)_3$(4-chlorobenzenesulfonate)$_2$ H$_2$O, où hyptrz = 4-(3'-hydroxpropyl)-1,2,4-triazole;
   $Fe(PM-Bia)_2(NCS)_2$, où PM-Bia = N-(2'-pyridyl-méthylène)-4-amino-biphényl;
   $Fe(PM-Aza)_2(NCS)_2$, où PM-Aza = N-(2'-pyridyl-méthylène)-4-(azophényl)aniline.

4. Dispositif de piézochrome **caractérisé en ce qu'**il renferme un composite de piézochrome conforme aux revendications 1-3 et des électrodes positionnées sur la matrice piézo-électrique, ces électrodes pouvant être reliées à une source de tension externe à la matrice par des lignes électriques.

5. Dispositif de piézochrome conforme à la revendication 4,
   **caractérisé en ce qu'**
   il renferme en outre un dispositif de stabilisation de la température, ce dispositif de stabilisation de la température étant positionné, relativement à la matrice de sorte que la source de courant externe à la matrice, soit également externe au dispositif de stabilisation de la température.

6. Utilisation d'un dispositif de piézochrome conforme à la revendication 5, en tant que partie d'un filtre optique contrôlable.

7. Utilisation d'un dispositif de piézochrome conforme à la revendication 4, en tant que partie d'un capteur de température pour détecter une valeur de seuil de température.

8. Utilisation d'un dispositif de piézochrome conforme à la revendication 5, en tant que partie d'un affichage optique.

Fig. 1

Fig. 2

Fig. 3

Fig. 4

10

9

Fig. 5

10

9

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Spin transitions in metal compounds I. Springer, 24 June 2004
- A helium-gas-pressure apparatus with optical reflectivity detection tested with a spin-transition solid. **JELENA JEFTIC et al.** MEASUREMENT SCIENCE AND TECHNOLOGY. IOP BRISTOL, 01 November 1999, vol. 10, 1059-1064
- Optically switchable thin films: a review. **GREENBERG et al.** THIN SOLID FILMS. ELSEVIER-SEQUIOA, 01 November 1994, vol. 251, 81-93
- Raman spectroscopic study of pressure effects on the Spin-crossover coordination polymers (Fe(Pyrazine)(M(CN)4).2H2O (M=Ni, Pd, Pt). First observation of a piezo-hystereses loop at room temperature. *Journal of Physical Chemistry,* 01 January 2003, vol. 107, 3149-3155